# EUROPÄISCHE PATENTANMELDUNG

(11) **EP 4 489 238 A1**
(43) Veröffentlichungstag der Anmeldung: **08.01.2025**
(21) Anmeldenummer: 24181067.0
(22) Anmeldetag: 10.06.2024
(51) Int. Cl.: H02B 1/20, H02B 1/36, H05K 7/14

(54) **KOMMUNIKATIONSANORDNUNG FÜR EINE SCHALTGERÄTEKOMBINATION MIT EINEM KABELKANAL**

(30) Priorität: 07.07.2023 DE 102023206468
(71) Anmelder: Siemens Aktiengesellschaft, 80333 München (DE)
(72) Erfinder: Gohlicke, Kay, 04442 Zwenkau (DE)
(74) Vertreter: Siemens Patent Attorneys

(57) **Zusammenfassung**

Die Erfindung betrifft eine Kommunikationsanordnung für eine Schaltgerätekombination. Die Kommunikationsanordnung besitzt einen wenigstens in einen ersten und einen zweiten Busabschnitt (19, 20) unterteilten drahtgebundenen Kommunikationsbus (19, 20), eine zwischen den ersten und den zweiten Busabschnitt (19, 20) geschaltete Abzweigplatine (1) und eine mit der Abzweigplatine (1) über eine Abzweigleitung (18) verbundene Komponente. Erfindungsgemäß besitzt die Kommunikationsanordnung außerdem einen Kabelkanal (10), der einen entlang einer Haupterstreckungsrichtung (11) verlaufenden Korpus (13) mit einer Bodenfläche (15) und zwei einander gegenüberliegenden, an die Bodenfläche (15) angrenzenden elastischen Seitenwänden (14) und einen Deckel (12) besitzt. Der Korpus (13) ist dabei dazu ausgebildet, den Deckel (12) formschlüssig (und gegebenenfalls zusätzlich kraftschlüssig) mit den Seitenwänden (14) zu halten. Die Seitenwände (14) weisen eine Mehrzahl von Durchgriffen (16) auf. Der erste und der zweite Busabschnitt (19, 20) verlaufen entlang der Haupterstreckungsrichtung (11) in dem Kabelkanal (10). Die Abzweigplatine (1) ist in dem Kabelkanal (10) angeordnet. Die Abzweigleitung (18) ist von der Abzweigplatine (1) durch einen der Durchgriffe (16) einer der Seitenwände (14) des Korpus (13) aus dem Kabelkanal (10) heraus zu der Komponente geführt.

## Beschreibung

### Technisches Gebiet

Die Erfindung betrifft eine Kommunikationsanordnung für eine Schaltgerätekombination, insbesondere eine Schaltgerätekombination gemäß EN61439 vom Oktober 2021, eine Schaltgerätekombination mit einer solchen Kommunikationsanordnung und eine Verwendung eines Kabelkanals in einer Schaltgerätekombination.

### Technischer Hintergrund

Elektrische oder elektronische Komponenten in Schaltgerätekombinationen wie Sensoren sollen kommunikationstechnisch an eine zentrale Steuereinheit angeschlossen werden. Kommunikationsbusse stellen insbesondere bei einer Vielzahl von anzuschließenden Komponenten eine wirtschaftliche Lösung gegenüber beispielsweise einer Punkt-zu-Punkt-Verbindung dar, da ein Abgriff von dem Kommunikationsbus in der Nähe der Komponente erfolgen kann.

Dieser Abgriff wird typischerweise durch Verteiler realisiert, ist meist als Steckverbindung ausgelegt und trägt damit Stecker oder Buchse. Ein Verteiler kann als minimaler Aufbau als T-Stück, bei höheren technischen Anforderungen jedoch auch als Leiterplatte (Abzweigplatine) ausgeführt werden. Eine solche Leiterplatte muss in der Schaltanlage befestigt werden und vor Beschädigung geschützt werden. Dazu sind Gehäuse in verschiedensten Bauformen möglich.

Derartige Gehäuse stellen einen erheblichen Kostenfaktor dar und liegen nur in ungeeigneten Formen und Größen vor. Applikationsspezifisch entwickelte Gehäuse sind zwar optimal von den Abmessungen auslegbar, aber nur bei einer Fertigung in hohen Stückzahlen wirtschaftlich. Verteiler für Schaltgerätekombinationen sind jedoch wenigstens aktuell keine Massenteile.

Die Erfindung macht es sich deshalb zur Aufgabe, eine verbesserte Kommunikationsanordnung für eine Schaltgerätekombination einzuführen.

Die Erfindung löst die Aufgabe durch eine Kommunikationsanordnung gemäß Anspruch 1, eine Schaltgerätekombination gemäß Anspruch 9 und eine Verwendung gemäß Anspruch 10. Vorteilhafte Ausführungsformen der erfindungsgemäßen Kommunikationsanordnung sind Gegenstand der Unteransprüche 2 bis 8.

### Zusammenfassung der Erfindung

Ein erster Aspekt der Erfindung führt eine Kommunikationsanordnung für eine Schaltgerätekombination ein. Die Kommunikationsanordnung besitzt einen wenigstens in einen ersten und einen zweiten Busabschnitt unterteilten drahtgebundenen Kommunikationsbus, eine zwischen den ersten und den zweiten Busabschnitt geschaltete Abzweigplatine und eine mit der Abzweigplatine über eine Abzweigleitung verbundene Komponente. Erfindungsgemäß besitzt die Kommunikationsanordnung außerdem einen Kabelkanal, der einen entlang einer Haupterstreckungsrichtung verlaufenden Korpus mit einer Bodenfläche und zwei einander gegenüberliegenden, an die Bodenfläche angrenzenden elastischen Seitenwänden und einen Deckel besitzt. Der Korpus ist dabei dazu ausgebildet, den Deckel formschlüssig (und gegebenenfalls zusätzlich kraftschlüssig) mit den Seitenwänden zu halten. Die Seitenwände weisen eine Mehrzahl von Durchgriffen auf. Der erste und der zweite Busabschnitt verlaufen entlang der Haupterstreckungsrichtung in dem Kabelkanal. Die Abzweigplatine ist in dem Kabelkanal angeordnet. Die Abzweigleitung ist von der Abzweigplatine durch einen der Durchgriffe einer der Seitenwände des Korpus aus dem Kabelkanal heraus zu der Komponente geführt.

Die Komponente kann im Rahmen dieser Erfindung insbesondere ein Sensor sein, beispielsweise ein Temperatur- oder ein Lichtsensor, wobei gleichermaßen sogenannte smarte Sensoren wie auch einfache Sensoren zum Einsatz kommen können. Als "smarter" Sensor wird hierbei ein Sensor verstanden, der selbständig Messwerte über den Kommunikationsbus übermitteln kann. In einem solchen Fall umfasst die Abzweigleitung wenigstens eine für eine solche Kommunikation ausgelegte Leitung.

Smarte Sensoren benötigen häufig - wie auch aktive Sensoren - eine Spannungsversorgung, so dass vorliegend der Kommunikationsbus und die Abzweigleitung zusätzlich zu den für die eigentliche Kommunikation vorgesehenen Leitungen Versorgungsleitungen enthalten können.

Als Schaltgerätekombination sind hier insbesondere Niederspannungsschaltanlagen und Motor-Control-Center zu verstehen. Besonders bevorzugt handelt es sich im Rahmen der Erfindung bei einer Schaltgerätekombination um eine Schaltgerätekombination im Sinne der Europäischen Norm EN61439 in der Fassung vom Oktober 2021.

Die Erfindung stellt eine einfache und kostengünstige Kommunikationsanordnung für den Einsatz in Schaltgerätekombinationen bereit. Die Kommunikationsanordnung kann einfach bemessen und installiert werden, beispielsweise um Sensoren wie insbesondere Temperatursensoren in ansonsten herkömmlich ausgestalteten Schaltgerätekombinationen bereitzustellen oder nachzurüsten. Die bei Verwendung eines Kommunikationsbusses, den sich mehrere Komponenten kostenreduzierend für die Kommunikation mit einer zentralen Steuereinheit datentechnisch teilen, eingesetzten Abzweigplatinen werden unmittelbar in dem für die Führung des Kommunikationsbusses verwendeten Kabelkanal untergebracht, wodurch die Abzweigplatinen gegenüber ihrer Umgebung und einem unerwünschten Verrutschen oder dergleichen geschützt sind. Als Kabelkanal kann dabei ein zu geringen Kosten aus Massenfertigung erhältlicher handelsüblicher Kabelkanal verwendet werden. Für die form- und ggf. zusätzlich kraftschlüssige Verbindung ist die Abzweigplatine dann passend zu dem verwendeten Kabelkanal dimensioniert, das heißt, die Abzweigplatine weist zwischen zwei in der fertigen Anordnung parallel zu den Seitenwänden des Kabelkanals verlaufenden und einander gegenüberliegenden Seiten eine Breite auf, die dem Abstand der Seitenwände des Kabelkanals wenigstens näherungsweise entspricht.

Die Abzweigplatine weist vorzugsweise an einer ersten Seite einen mit dem ersten Busabschnitt lösbar verbundenen ersten Anschluss und an einer der ersten Seite gegenüberliegenden zweiten Seite einen mit dem zweiten Busabschnitt lösbar verbundenen zweiten Anschluss auf. Durch die Verwendung von lösbaren Anschlüssen wird die Installation der Kommunikationsanordnung besonders schnell möglich und es können vorkonfektionierte Kabellängen für die einzelnen Busabschnitte verwendet werden. Überschüssige Kabellänge, die bei einer Länge eines Busabschnitts, die geringer als die vorkonfektionierte Kabellänge ist, kann dabei einfach in einer Schlaufe in dem Kabelkanal verstaut werden.

Die Abzweigplatine und der Korpus des Kabelkanals sind besonders bevorzugt derart aufeinander abgestimmt dimensioniert, dass der Korpus dazu ausgebildet ist, die Abzweigplatine zwischen seinen Seitenwänden zu halten. Die Abzweigplatine wird dabei vorzugsweise formschlüssig und besonders bevorzugt zusätzlich kraftschlüssig von den Seitenwänden des Kabelkanals gehalten. Dadurch wird die Installation der Abzweigplatine besonders einfach, da sie lediglich an der gewünschten Stelle für einen Abzweig in den Kabelkanal eingesetzt und (bei zusätzlicher kraftschlüssiger Verbindung) mit geringer Kraft festgedrückt werden muss.

Die Abzweigplatine kann an einer dritten Seite und an einer der dritten Seite gegenüberliegenden vierten Seite jeweils wenigstens einen Zahn aufweist, wobei die Durchgriffe des Kabelkanals und die Zähne derart aufeinander abgestimmt dimensioniert sind, dass die Durchgriffe dazu ausgebildet sind, die Zähne zu halten. Die Zähne greifen also in die Durchgriffe ein und verhindern, dass die Abzweigplatine - etwa durch versehentlich ausgeübte Zugkräfte auf den Busabschnitten - im Kabelkanal entlang dessen Haupterstreckungsrichtung verrutscht. Beispielsweise kann die Abzweigplatine auf jeder an die Seitenwände des Kabelkanals angrenzenden Seite eine Mehrzahl von Zähnen aufweisen, die entsprechend dem Raster der Durchgriffe in den Seitenwänden des Kabelkanals beabstandet sind.

Vorzugsweise weist die Bodenfläche des Korpus des Kabelkanals eine Mehrzahl von Löchern auf. Die Löcher ermöglichen eine einfache Befestigung des Kabelkanals beispielsweise durch eine an passender Stelle durch eines der Löcher geführte Schraubverbindung.

Die Durchgriffe der Seitenwände des Korpus können auf einer von der Bodenfläche des Korpus wegweisenden Seite geöffnet sein, so dass die Seitenwände des Korpus eine Kammform besitzen. Dadurch kann bei entferntem Deckel des Kabelkanals die Abzweigleitung einfach durch die Seitenwand des Kabelkanals geführt werden (sozusagen zwischen zwei benachbarten Zinken der kammförmigen Seitenwand hindurch) und wird nach anschließender Befestigung des Deckels auf dem Korpus des Kabelkanals ortsfest gehalten.

Vorzugsweise besteht der Kabelkanal aus einem elastischen Kunststoff, beispielsweise Polyvenylchlorid (PVC).

Die Abzweigplatine kann einen dritten Anschluss für die Abzweigleitung aufweisen. In diesem Fall ist die Abzweigleitung lösbar mit der Abzweigplatine verbunden. Alternativ kann die Abzweigleitung jedoch auch fest mit der Abzweigplatine verbunden sein, beispielsweise verlötet.

Ein zweiter Aspekt der Erfindung betrifft eine Schaltgerätekombination, insbesondere eine Schaltgerätekombination gemäß EN61439 vom Oktober 2021, mit einer Mehrzahl von Geräteeinschüben, einer Steuereinheit und einer Kommunikationsanordnung gemäß dem ersten Erfindungsaspekt, wobei die Komponente der Kommunikationsanordnung an einem der Geräteeinschübe angeordnet ist und wobei die Steuereinheit mit dem Kommunikationsbus verbunden ist. Die Steuereinheit kann beispielsweise bei Verwendung mit einem oder mehreren Temperatursensoren dazu dienen, eine unerwünscht hohe Temperatur zu detektieren und in der Schaltgerätekombination zu lokalisieren, um durch Ausgabe eines Warnsignals eine Beschädigung der Schaltgerätekombination zu verhindern oder eine Wartungsmaßnahme zu veranlassen.

Ein weiterer Aspekt der Erfindung betrifft eine Verwendung eines Kabelkanals in einer Schaltgerätekombination, insbesondere eine Schaltgerätekombination gemäß EN61439 vom Oktober 2021, als Gehäuse für einen in wenigstens einen ersten und einen zweiten Busabschnitt unterteilten drahtgebundenen Kommunikationsbus und eine zwischen den ersten Busabschnitt und den zweiten Busabschnitt geschalteten Abzweigplatine. Dabei ist die Abzweigplatine über eine durch einen Durchgriff von mehreren Durchgriffen in einer von zwei einander gegenüberliegenden Seitenwänden des Kabelkanals geführte Abzweigleitung mit einer Komponente verbunden.

### Kurzbeschreibung der Figuren

Die Erfindung wird nachfolgend anhand von Abbildungen von Ausführungsbeispielen näher erläutert, wobei gleiche Bezugszeichen gleiche oder gleichartige Merkmale bezeichnen. Es zeigen:
Fig. 1 ein Ausführungsbeispiel einer Abzweigplatine 1 für den Einsatz in einer erfindungsgemäßen Kommunikationsanordnung;
Fig. 2 ein Ausführungsbeispiel eines Kabelkanals 10 für den Einsatz in einer erfindungsgemäßen Kommunikationsanordnung;
Fig. 3 die Abzweigplatine 1 von Figur 1 eingesetzt in einen teilweise dargestellten Kabelkanal 10;
Fig. 4 ein Ausführungsbeispiel einer erfindungsgemäßen Kommunikationsanordnung in einer Teildarstellung;
Fig. 5 ein weiteres Ausführungsbeispiel einer erfindungsgemäßen Kommunikationsanordnung in einer weiteren Teildarstellung; und
Fig. 6 ein weiteres Ausführungsbeispiel einer erfindungsgemäßen Kommunikationsanordnung in einer Schnittdarstellung.

### Ausführliche Beschreibung der Figuren

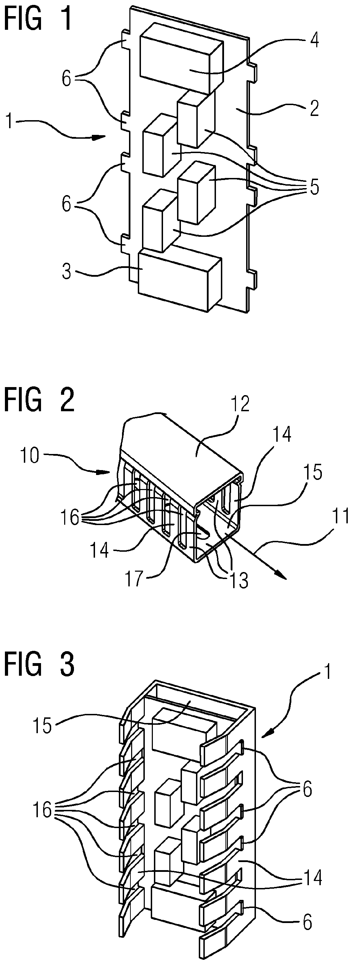

Fig. 1 zeigt ein Ausführungsbeispiel einer Abzweigplatine 1 für den Einsatz in einer erfindungsgemäßen Kommunikationsanordnung. Die Abzweigplatine des Ausführungsbeispiels besitzt ein PCB (Printed Circuit Board) 2 mit einer im wesentlichen rechteckigen Grundform. An zwei einander gegenüberliegenden Seiten besitzt die Abzweigplatine 1 des Ausführungsbeispiels mehrere Ausformungen oder Zähne 6, die einander paarweise gegenüberliegen. Die Zähne 6 dienen zur Verankerung des Abzweigplatine 1, wie weiter unten ausführlicher erläutert wird.

Die Abzweigplatine 1 des Ausführungsbeispiels besitzt erste und zweite Anschlüsse 3, 4 für jeweilige Busabschnitte eines drahtgebundenen Kommunikationsbusses. Ferner sind vorliegend mehrere dritte Anschlüsse 5 auf der Abzweigplatine 1 vorgesehen, die für das Anschließen von Abzweigleitungen (nicht dargestellt) vorgesehen sind.

Fig. 2 zeigt ein Ausführungsbeispiel eines Kabelkanals 10 für den Einsatz in einer erfindungsgemäßen Kommunikationsanordnung. Der in der Figur nur in einem kleinen Ausschnitt dargestellte Kabelkanal 10 ist gattungsüblich länglich ausgestaltet und erstreckt sich in seiner Längsrichtung entlang einer Haupterstreckungsrichtung 11. Der Kabelkanal 10 besitzt dabei einen Deckel 12, der lösbar mit einem Korpus 13 verbunden ist und diesen verschließt. Der Korpus 13 des Kabelkanals 10 besitzt eine Bodenfläche 15 und einander gegenüberliegende Seitenwände 14. Die Bodenfläche 15 weist in dem gezeigten Ausführungsbeispiel mehrere Löcher 17 auf, die zur Befestigung des Kabelkanals an einer Wand oder ähnlichem beispielsweise durch eine Schraubverbindung, einen Bolzen oder einen Niet dient. Die beiden Seitenwände 14 weisen eine Vielzahl Durchgriffe 16 auf, wodurch die Seitenwände 14 bei entferntem Deckel 12 eine Kammform mit zwischen den Durchgriffen 16 befindlichen "Zinken" besitzen. Der Kabelkanal 10 ist vorzugsweise aus einem elastischen Material wie PVC gefertigt. Durch die Elastizität des Materials kann der Deckel 12 lösbar mit den Seitenwänden 14 verbunden werden.

Kabelkanal 10 und Abzweigplatine 1 sind dabei derart aufeinander abgestimmt dimensioniert, dass die Abzweigplatine 1 in dem Kabelkanal 10 angeordnet werden kann und dabei von den Seitenwänden 14 gehalten wird. Besitzt die Abzweigplatine 1 - wie in Figur 1 gezeigt - Zähne 6, sind diese hinsichtlich ihrer Größe und ihres Abstandes so bemessen, dass die Zähne 6 in die Durchgriffe 16 in den Seitenwänden 14 des Kabelkanals 10 eingreifen können, wodurch die Abzweigplatine 1 besseren Halt in dem Kabelkanal 10 bekommt und insbesondere nicht in dem Kabelkanal 10 entlang dessen Haupterstreckungsrichtung 11 verrutschen kann. Fig. 3 zeigt die Abzweigplatine 1 von Figur 1 dergestalt eingesetzt in einen (hier nur teilweise dargestellten) Kabelkanal 10, wie in Figur 2 gezeigt.

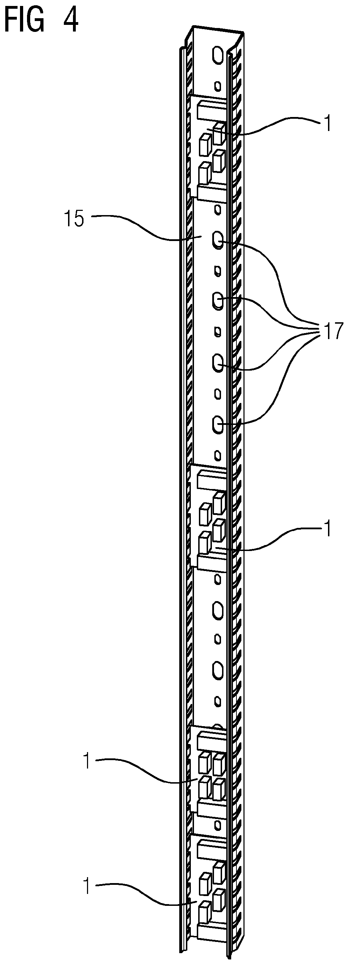

Fig. 4 zeigt ein Ausführungsbeispiel einer erfindungsgemäßen Kommunikationsanordnung in einer Teildarstellung, bei dem mehrere Abzweigplatinen 1 entlang der Haupterstreckungsrichtung des Kabelkanals verteilt in den Kabelkanal eingesetzt sind. Der Kabelkanal wird dabei ohne seinen Deckel gezeigt, um die Einsicht in sein Inneres zu erlauben. Bei der Installation einer erfindungsgemäßen Kommunikationsanordnung können die Abzweigplatinen 1 an den für das Anschließen einer jeweiligen Komponente vorgesehenen Stellen des drahtgebundenen Kommunikationsbusses in den bereits in der Schaltgerätekombination (nicht dargestellt) durch Löcher 17 in der Bodenfläche 15 des Kabelkanals geführte Befestigungsmittel montierten Korpus des Kabelkanals eingesetzt werden. Die Seitenwände des Kabelkanals halten die Abzweigplatinen 1, wie oben erläutert, an dem jeweils für sie vorgesehenen Ort. Anschließend können die einzelnen Busabschnitte, die sich zwischen jeweils zwei benachbarten Abzweigplatinen 1 erstrecken, in den Kabelkanal eingelegt und durch Steckverbindungen mit den Abzweigplatinen 1 verbunden werden. Die für die Verbindung der Komponenten vorgesehenen Abzweigleitungen werden anschließend mit den Abzweigplatinen 1 verbunden und durch neben der jeweiligen Abzweigplatine 1 gelegene Durchgriffe 16 in der Seitenwand des Kabelkanals geführt. Wenn die Verkabelung abgeschlossen ist, wird der Deckel auf dem Korpus des Kabelkanals befestigt, wodurch die Busabschnitte, Abzweigplatinen und Abzweigleitungen an den für sie vorgesehenen Orten gehalten werden. Die Installation der erfindungsgemäßen Kommunikationsanordnung ist somit schnell und einfach möglich, die einzelnen Teile der Kommunikationsanordnung sind zudem gegenüber ihrer Umgebung abgeschirmt und werden durch den Kabelkanal ortsfest gehalten.

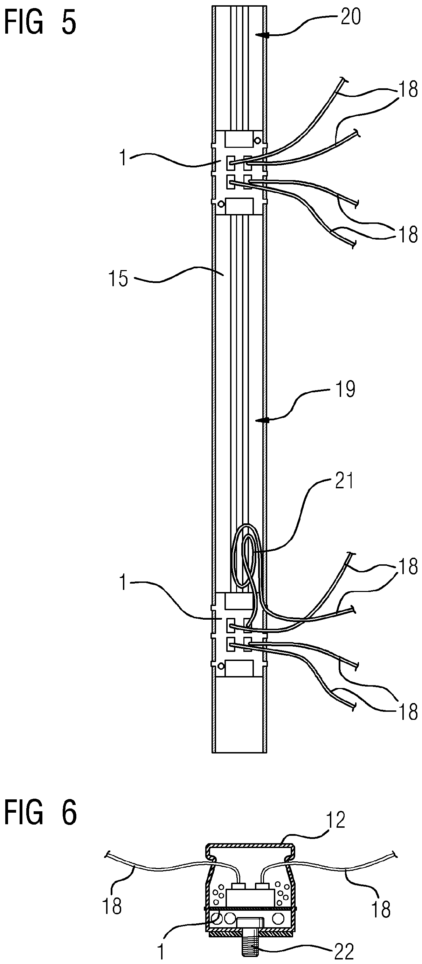

Fig. 5 zeigt ein weiteres Ausführungsbeispiel einer erfindungsgemäßen Kommunikationsanordnung in einer weiteren Teildarstellung, wobei die Verkabelung der Abzweigplatinen 1 wenigstens teilweise fertiggestellt ist. Dabei ist beispielhaft eine der Abzweigleitungen 18 in eine freigewickelte Schlaufe 21 gelegt, die innerhalb des Kabelkanals angeordnet ist. Dies verdeutlicht einen weiteren Vorteil der erfindungsgemäßen Anordnung, der es erlaubt, vorkonfektionierte Kabel für die Busabschnitte und/oder Abzweigleitungen zu verwenden und überschüssige Kabellänge im Kabelkanal zu verstauen.

Fig. 6 zeigt ein weiteres Ausführungsbeispiel einer erfindungsgemäßen Kommunikationsanordnung in einer Schnittdarstellung. Der Kabelkanal ist bei dem gezeigten Ausführungsbeispiel mit einer in der Schnittebene der Schnittdarstellung liegenden Schraube 22 befestigt. Neben den mit Bezugszeichen versehenen und im Zusammenhang mit den vorhergehenden Abbildungen beschriebenen Teilen der Kommunikationsanordnung sind vorliegend nicht näher bezeichnete und durch kreisförmige Querschnitte bezeichnete weitere Kabel in dem Kabelkanal angedeutet. Naturgemäß kann der Kabelkanal der erfindungsgemäßen Kommunikationsanordnung für das Verlegen weiterer, nicht mit der Kommunikationsanordnung unmittelbar in technischer Verbindung stehender Kabel verwendet werden.

Die Erfindung wurde unter Bezugnahme auf Ausführungsbeispiele näher beschrieben. Die gezeigten Ausführungsbeispiele dienen dem besseren Verständnis und sollen die Erfindung, die ausschließlich durch die nachfolgenden Ansprüche definiert wird, nicht einschränken.

### Bezugszeichenliste

- 1: Abzweigplatine
- 2: PCB
- 3: erster Anschluss
- 4: zweiter Anschluss
- 5: dritter Anschluss
- 6: Zahn
- 10: Kabelkanal
- 11: Haupterstreckungsrichtung
- 12: Deckel
- 13: Korpus
- 14: Seitenwand
- 15: Bodenfläche
- 16: Durchgriff
- 17: Loch
- 18: Abzweigleitung
- 19: erster Busabschnitt
- 20: zweiter Busabschnitt
- 21: Schlaufe
- 22: Schraube

## Patentansprüche

1. Eine Kommunikationsanordnung für eine Schaltgerätekombination mit einem wenigstens in einen ersten und einen zweiten Busabschnitt (19, 20) unterteilten drahtgebundenen Kommunikationsbus (19, 20), einer zwischen den ersten und den zweiten Busabschnitt (19, 20) geschalteten Abzweigplatine (1) und eine mit der Abzweigplatine (1) über eine Abzweigleitung verbundene Komponente, **gekennzeichnet durch** einen Kabelkanal (10), der einen entlang einer Haupterstreckungsrichtung (11) verlaufenden Korpus (13) mit einer Bodenfläche (15) und zwei einander gegenüberliegenden, an die Bodenfläche (15) angrenzenden elastischen Seitenwänden (14) und einen Deckel (12) besitzt, wobei der Korpus (13) dazu ausgebildet ist, den Deckel (12) formschlüssig mit den Seitenwänden (14) zu halten, wobei die Seitenwände (14) eine Mehrzahl von Durchgriffen (16) aufweisen und wobei der erste und der zweite Busabschnitt (19, 20) entlang der Haupterstreckungsrichtung (11) in dem Kabelkanal (10) verlaufen, die Abzweigplatine (1) in dem Kabelkanal (10) angeordnet ist und die Abzweigleitung (18) von der Abzweigplatine (1) durch einen der Durchgriffe (16) einer der Seitenwände (14) des Korpus (13) aus dem Kabelkanal (10) heraus zu der Komponente geführt ist.

2. Die Kommunikationsanordnung des vorhergehenden Anspruchs, bei der die Abzweigplatine (1) an einer ersten Seite einen mit dem ersten Busabschnitt (19) lösbar verbundenen ersten Anschluss (3) und an einer der ersten Seite gegenüberliegenden zweiten Seite einen mit dem zweiten Busabschnitt (20) lösbar verbundenen zweiten Anschluss (4) aufweist.

3. Die Kommunikationsanordnung eines der vorhergehenden Ansprüche, bei der die Abzweigplatine (1) und der Korpus (13) des Kabelkanals (10) derart aufeinander abgestimmt dimensioniert sind, dass der Korpus (13) dazu ausgebildet ist, die Abzweigplatine (1) zwischen seinen Seitenwänden (14) zu halten.

4. Die Kommunikationsanordnung des vorhergehenden Anspruchs, bei der die Abzweigplatine (1) an einer dritten Seite und an einer der dritten Seite gegenüberliegenden vierten Seite jeweils wenigstens einen Zahn (6) aufweist, wobei die Durchgriffe (16) des Kabelkanals (10) und die Zähne (6) derart aufeinander abgestimmt dimensioniert sind, dass die Durchgriffe (16) dazu ausgebildet sind, die Zähne (6) zu halten.

5. Die Kommunikationsanordnung eines der vorhergehenden Ansprüche, bei der die Bodenfläche (15) des Korpus (13) des Kabelkanals (10) eine Mehrzahl von Löchern (17) aufweist.

6. Die Kommunikationsanordnung eines der vorhergehenden Ansprüche, bei der die Durchgriffe (16) der Seitenwände (14) des Korpus (13) auf einer von der Bodenfläche (15) des Korpus (13) wegweisenden Seite geöffnet sind, so dass die Seitenwände (14) des Korpus (13) eine Kammform besitzen.

7. Die Kommunikationsanordnung eines der vorhergehenden Ansprüche, bei der der Kabelkanal (10) aus einem elastischen Kunststoff besteht.

8. Die Kommunikationsanordnung eines der vorhergehenden Ansprüche, bei der die Abzweigplatine (1) einen dritten Anschluss (5) für die Abzweigleitung (18) aufweist und die Abzweigleitung (18) lösbar mit der Abzweigplatine (1) verbunden ist.

9. Eine Schaltgerätekombination mit einer Mehrzahl von Geräteeinschüben, einer Steuereinheit und einer Kommunikationsanordnung gemäß einem der vorhergehenden Ansprüche, wobei die Komponente der Kommunikationsanordnung an einem der Geräteeinschüben angeordnet ist und wobei die Steuereinheit mit dem Kommunikationsbus (19, 20) verbunden ist.

10. Verwendung eines Kabelkanals (10) in einer Schaltgerätekombination als Gehäuse für einen in wenigstens einen ersten und einen zweiten Busabschnitt (19, 20) unterteilten drahtgebundenen Kommunikationsbus (19, 20) und eine zwischen den ersten Busabschnitt (19) und den zweiten Busabschnitt (20) geschalteten Abzweigplatine (1), wobei die Abzweigplatine (1) über eine durch einen Durchgriff (16) von mehreren Durchgriffen (16) in einer von zwei einander gegenüberliegenden Seitenwänden (14) des Kabelkanals (10) geführte Abzweigleitung (18) mit einer Komponente verbunden ist.
